(19) Europäisches Patentamt
European Patent Office
Office européen des brevets

(11) Veröffentlichungsnummer: **0 061 150**
**B1**

(12) # EUROPÄISCHE PATENTSCHRIFT

(45) Veröffentlichungstag der Patentschrift: **15.10.86**

(51) Int. Cl.⁴: **G 03 C 1/54,** C 08 G 61/00 // G03F7/08, G03F7/26

(21) Anmeldenummer: **82102194.6**

(22) Anmeldetag: **18.03.82**

(54) **Lichtempfindliches Polykondensationsprodukt, Verfahren zu seiner Herstellung und dieses enthaltendes lichtempfindliches Aufzeichnungsmaterial.**

(30) Priorität: **20.03.81 US 245837**

(43) Veröffentlichungstag der Anmeldung: **29.09.82 Patentblatt 82/39**

(45) Bekanntmachung des Hinweises auf die Patenterteilung: **15.10.86 Patentblatt 86/42**

(84) Benannte Vertragsstaaten: **BE CH DE FR GB IT LI NL SE**

(56) Entgegenhaltungen:
**DE-A-2 024 242**
**US-A-3 679 419**
**US-A-3 849 392**
**US-A-3 867 147**

(73) Patentinhaber: **AMERICAN HOECHST CORPORATION, Route 202- 206 North, Somerville, N.J. 08876 (US)**

(72) Erfinder: **Walls, John E., 46 Center Street, Annandale, N.J. 08801 (US)**

(74) Vertreter: **Euler, Kurt Emil, Dr., KALLE Niederlassung der Hoechst AG Rheingaustrasse 190 Postfach 3540, D-6200 Wiesbaden 1 (DE)**

EP 0 061 150 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

**Beschreibung**

Die Erfindung betrifft neue lichtempfindliche Kondensationsprodukte aromatischer Diazoniumsalze und Verfahren zu ihrer Herstellung sowie lichtempfindliche Aufzeichnungsmaterialien, bestehend aus einem Träger und einer darauf aufgebrachten Aufzeichnungsschicht, die mindestens eines der neuen lichtempfindlichen Produkte enthält.

Es ist bekannt, lichtempfindliche aromatische Diazoniumverbindungen zur Sensibilisierung von Aufzeichnungsmaterialien für die Herstellung von Einzelkopien, Druckplatten, Siebdruckschablonen und Farbprüffolien sowie für andere Anwendungen in der Aufzeichnungstechnik zu benutzen.

Diazoniumsalz-Mischkondensationsprodukte, die Einheiten $A-N_2X$ von aromatischen Diazoniumsalzen und Einheiten B von damit kondensierbaren, von Diazoniumgruppen freien Verbindungen enthalten, sind in den US-A 3 867 147, 3 679 419 und 3 849 392 beschrieben. Nach den allgemeinen Angaben der US-A 3 849 392 können 0,01 bis 50 Einheiten B je Einheit $A-N_2X$ vorliegen, wobei über die Art der Verknüpfung von gegebenenfalls vorhandenen überschüssigen Einheiten B mit $A-N_2X$ und untereinander nichts ausgesagt ist. Das bevorzugte Mengenverhältnis beträgt 0,2 bis 2 Einheiten B je Einheit $A-N_2X$, was auch von der überwiegenden Zahl der Beispiele bestätigt wird. Da die Verknüpfung der Einheiten untereinander in statistischer Verteilung erfolgt, tritt ein Überschuß an B teils als Endglieder, teils als Verzweigungsstellen mit drei oder mehr Einheiten B an einer Einheit $A-N_2X$ und teils durch unmittelbare Verknüpfung von zwei oder mehreren Einheiten B miteinander in Erscheinung. Im Mittel sind deshalb bei einem Molverhältnis $A-N_2X$: B von 1: 2 weniger als zwei Einheiten B unmittelbar miteinander verbunden. Im wesentlichen die gleiche Offenbarung findet sich in den beiden anderen oben genannten Dokumenten.

Die in diesen Patentschriften beschriebenen Diazomischkondensate erfüllen zwar ihren Zweck und sind wirtschaftlich erfolgreich, jedoch besteht auf drucktechnischem Gebiet weiterhin ein Bedarf an Materialien mit erhöhter Lichtempfindlichkeit.

Für die Laserbelichtung und die bebilderung durch Projektion werden Druckplatten benötigt, die nicht nur eine höhere Lichtempfindlichkeit haben, sondern gleichzeitig alle Vorteile der bekannten Produkte aufweisen, d. h. sie müssen als vorsensibilisierte Platten eine gute Stabilität haben, feuchtigkeitsbeständig sein und hohe, gleichbleibend gute Druckauflagen ermöglichen. Ferner müssen solche Platten stark oleophile Bildstellen und hydrophile Nichtbildstellen haben.

Aufgabe der Erfindung ist es, Druckplatten auf Basis von negativ arbeitenden Diazoniumsalz-Mischkondensaten vorzuschlagen, die eine höhere Lichtempfindlichkeit zeigen als die bekannten Druckplatten dieser Gattung.

Erfindungsgemäß wird ein neues lichtempfindliches Polykondensationsprodukt aus wiederkehrenden Einheiten der allgemeinen Typen

$$[A - N_2X] \quad . \quad \text{und} \quad [Q]$$

vorgeschlagen, das dadurch gekennzeichnet ist, daß
A der Rest einer Verbindung der allgemeinen Formel 1

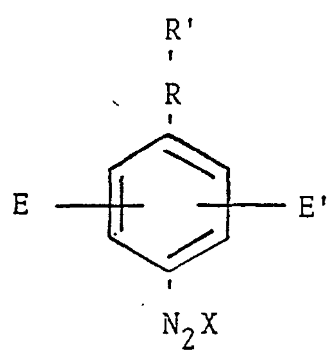

(I)

ist, worin
R' eine substituierte oder unsubstituierte Phenylgruppe darstellt,
R -NH-, -S-, -O-, $-CH_2-$ oder eine Einfachbindung ist,
E und E' gleich oder verschieden sein können und Alkyloder Alkoxygruppen mit 1 bis 4 C-Atomen oder Wasserstoffatome sind und
X das Anion des Diazoniumsalzes ist,
Q der Rest einer Verbindung der allgemeinen Formel II

$$\begin{array}{c} T \\ | \\ R''\text{-}M(\text{-}Y\text{-}M)_m\text{-}R'' \end{array} \qquad (II)$$

ist, worin

R'' $-CH_2OH$, $-C(OH)(CH_3)_2$, $-CH_2O(CH_2)_nCH_3$, $CH_2OC(=O)CH_3$, $-CH_2Cl$ oder $-CH_2Br$,

n 0 oder eine Zahl von 1 bis 3,

M der Rest eines aromatischen Kohlenwasserstoffs, Phenolethers, aromatischen Thioethers, aromatischen Amins, aromatischen Sulfons, aromatischen Ketons oder Diketons, wobei diese Grundkörper unsubstituiert oder durch Reste, die die Kondensationsreaktion nicht stören, substituiert sind,

m eine Zahl von 1 bis 6,

Y $-CH_2-$ oder $-CH_2OCH_2-$ und

T ein Wasserstoffatom ist, wenn Y $-CH_2-O-CH_2-$bedeutet, und ein Rest R'' ist, wenn Y $-CH_2-$bedeutet.

Erfindungsgemäß wird ferner ein Verfahren zur Herstellung des oben definierten Kondensationsprodukts vorgeschlagen, das darin besteht, daß man

a) in einem stark sauren Medium eine Verbindung der Formel R''-M-R'' so lange und bei solcher Temperatur kondensiert, daß ein Vorkondensationsprodukt der Formel gebildet wird, worin die Symbole die oben angegebene Bedeutung haben, und

b) das erhaltene Vorkondensationsprodukt in stark saurem Medium mit einer Verbindung der Formel 1 kondensiert, worin die Symbole ebenfalls die oben angegebene Bedeutung haben.

Es wird ferner ein lichtempfindliches Aufzeichnungsmaterial aus einem Schichtträger und einer lichtempfindlichen Schicht vorgeschlagen, das dadurch gekennzeichnet ist, daß die lichtempfindliche Schicht ein lichtempfindliches Polykondensationsprodukt der oben angegebenen Zusammensetzung enthält.

Die neuen oligomeren Vorkondensationsprodukte der Formel II sind im wesentlichen lineare, zur Reaktion mit aromatischen Diazoniumverbindungen befahigte Oligomere und Oligomerengemische, die man durch Kondensation einer Verbindung R''-M-R'' erhält.

Aromatische Kohlenwasserstoffe, die unter M fallen, können Benzol, Naphthalin, Anthracen und andere kondensierte aromatische Verbindungen, Diphenyl, Diarylalkane. z. B. Diphenylmethan, Diphenylethan und Diphenylisopropan und ähnliche Stoffe umfassen. Die aromatischen Kohlenwasserstoffe sowie Arylreste innerhalb der Definition von M können auch von R'' verschiedene Ringsubstituenten enthalten, wenn diese die Kondensationsreaktion nicht storen. Zu diesen Substituenten zählen Halogenatome, Hydroxy-, niedere Alkyl-Phenyl- und Phenoxygruppen.

Vor dem Kondensieren können zwei verschiedene Verbindungen R''-M-R'' gemischt werden, wobei dann eine Cokondensation stattfindet. In diesen Fallen können kondensierbare Monomere verwendet werden, die Reste R'', M und T mit unterschiedlichem chemischen Aufbau enthalten.

Als Anionen X sind solche geeignet, die dem Diazoniumsalz Wasserlöslichkeit verleihen oder die Auflösung in der gewahlten Kondensationssäure ermöglichen.

Bevorzugte Anionen sind $SO_4$, $PO_4$, Cl, Br, F und $NO_3$.

Der Reaktionsmechanismus läßt darauf schließen, daß das Oligomere und die aromatische Diazoniumverbindung in erster Linie durch Methylengruppen verbunden sind.

Zur Herstellung von Aufzeichnungsschichten werden die neuen lichtempfindlichen Verbindungen auf einen Trager aufgebracht. Druckplatten, die mit diesen Verbindungen hergestellt worden sind, weisen im Vergleich zu bekannten Platten eine etwa 2-bis 11-mal höhere Lichtempfindlichkeit bei unverändert guter Auflage auf.

Zur Herstellung des oligomeren Vorkondensationsprodukts sind zahlreiche Monomere geeignet, wie nachfolgend ausgeführt wird. Als Reaktionsbeispiel wird 4,4'-Bis-methoxymethyl-diphenyl-sulfid in 85%-iger Orthophosphorsäure aufgelöst. Es entsteht zunächst ein Dimeres durch Kondensation einer Methoxymethylgruppe mit einem aromatischen Kohlenstoffatom eines anderen Molekuls unter Austritt von Methanol.

Wird die Reaktion durch Kondensation einer weiteren Monomereneinheit fortgesetzt, so bildet sich ein Trimeres. Auf ühnliche Weise entstehen Tetramere und Pentamere. Die Oligomerisationsreaktion wird unter Kontrolle gehalten und vorzugsweise dann zum Stillstand gebracht, wenn noch keine höheren Homologen als das Heptamere gebildet worden sind. Die obere Grenze ist nicht kritisch, deckt sich jedoch zweckmäßig mit dem Beginn der teilweisen Unlöslichkeit des rohen oligomeren Reaktionsproduktes. Das Reaktionsgemisch enthält nun unverändert monomere, dimere, trimere und höhere Moleküle, bis zum höchsten entstandenen Oligomeren.

Wie aus Beispiel 11 ersichtlich wird, ist es möglich, das Gemisch aufzutrennen und die einzelnen

Oligomerenfraktionen zu isolieren. Das ist jedoch im allgemeinen nicht nötig, sofern nicht die größtmögliche Lichtempfindlichkeit, ungeachtet einer eventuellen nachteiligen Wirkung auf die Lagerfähigkeit, gewünscht wird.

Wie bereits erwähnt, wird das Oligomerengemisch dann mit einem bekannten Diazomonomeren kondensiert. Als Beispiel wird Diphenylamin-4-diazonium-dihydrogenphosphat gewählt. Dieses Salz wird in 85 %-iger (wenn nichts anderes angegeben ist, sind alle Prozentangaben in Gew.-%) Orthophosphorsäure aufgelöst, mit dem Oligomerengemisch versetzt und zu einem Diazonium-Kondensationspolymeren kondensiert, das aus wiederkehrenden Einheiten von Gruppierungen des Oligomeren [Q] und des Diazomonomeren [$A-N_2X$] besteht. Durch Isolieren des Produkts als Phosphat, Chlorid, Bromid oder Sulfat ergibt sich ein wasserlösliches Diazoniumsalz. Wird das Produkt als aromatisches Sulfonat, Hexafluorophosphat oder Tetrafluoroborat isoliert, so erhält man ein in organischen Lösemitteln lösliches Diazoniumsalz. Diese Salze lassen sich zum Beispiel für die Herstellung von Druckplatten verwenden, wobei man sie auf einen Aluminiumträger aufbringt. Ihre Lichtempfindlichkeit ist wesentlich höher als die der bisher bekannten Diazoniumsalz-Kondensationsprodukte.

Zahlreiche Monomere R''-M-R'' eignen sich für die Oligomerisation, und ihre Oligomeren können für die Kondensation mit Diazomonomeren zu den erfindungsgemäßen neuen Diazoniumsalz-Kondensationsprodukten eingesetzt werden. Eine Reihe dieser Monomeren ist nachfolgend aufgeführt.

Bevorzugte Monomere sind solche, in denen M der Rest eines gegebenenfalls substituierten Benzols oder einer gegebenenfalls substituierten Diphenylverbindung ist, z. B. von Diphenylether, Diphenylmethan, Diphenylethan, Diphenylsulfid, Diphenylsulfon, Diphenylamin oder eines Diphenylketons.

**Diazofreie Monomere**

Für die Homo- oder Cokondensation geeignete Monomere sind zum Beispiel:
1,3-Di-hydroxymethyl-benzol
1,4-Di-methoxymethyl-benzol
1,5-Di-acetoxymethyl-naphthalin
1,4-Di-hydroxymethyl-naphthalin
9,10-Di-methoxymethyl-anthracen
2,5-Di-methoxymethyl-thiophen
1,4-Bis-(2-hydroxy-prop-2-yl)benzol
2,6-Bis-hydroxymethyl-naphthalin
4,6-Dimethyl-1,3-di-hydroxymethyl-benzol
2,4,6-Trimethyl-1,3-di-hydroxymethyl-benzol
2,3,5,6-Tetramethyl-1,4-di-acetoxymethyl-benzol
4,4'-Bis-acetoxymethyl-diphenylmethan
2-Ethyl-9,10-bis-methoxymethyl-anthracen
4,4'-Bis-acetoxymethyl-diphenylsulfon
4,4,-Bis-methoxymethyl-benzophenon
6-Acetoxy-3-methyi-1,5-di-acetoxymethyl-benzol
5-Benzyl-2-acetoxy-1,3-bis-acetoxymethyl-benzol
4-Hydroxy-3,5'-bis-hydroxymethyl-diphenylether
Bis-(4-hydroxy-5-methyl-3-hydroxymethyl-phenyl)sulfon
1,3-Bis-(3-hydroxymethyl-phenoxy)propan
1,3-Bis-methoxymethyl-2-ethoxy-5-brom-benzol
2,2'-Dimethoxy-3,3'-bis-hydroxymethyl-5,5'-dimethyl-diphenylmethan
Bis-hydroxymethyl-hydrochinondimethylether
4-Methoxymethyl-diphenylether
4,4'-Bis-hydroxymethyl-diphenylether
4,4'-Bis-methoxymethyl-diphenylether
2,4,4'-Tris-methoxymethyl-diphenylether
3,3'-Bis-methoxymethyl-4,4'-dimethyl-diphenylether
3,3'-Bis-methoxymethyl-2,4'-dimethoxy-diphenylsulfid
1,3-(4-Methoxymethyl-phenoxy)benzol
3,3'-Bis-methoxymethyl-4-phenoxy-diphenylsulfid
4,4'-Bis-methoxymethyl-benzil
Weitere zur Cokondensation mit den oben aufgeführten Monomeren geeignete Monomere sind z. B:
Benzylalkohol
Dibenzylether
1-Hydroxymethyl-naphthalin
9-Hydroxymethyl-phenanthren
2-Hydroxymethyl-furan
Benzhydrol

2,5-Dimethyl-hydroxymethyl-benzol
2,2'-Bis-hydroxymethyl-dibenzylether

Im Folgenden werden Beispiele für besonders bevorzugte Monomere genannt:

4,4'-Bis-hydroxymethyl-diphenylether
4,4'-Bis-acetoxymethyl-diphenylether
4,4'-Bis-methoxymethyldiphenylether
2,4'-Bis-methoxymethyl-diphenylether
3,3'-Bis-methoxymethyl-4,4'-dimethyl-diphenylether
4,4'-Bis-methoxymethyl-diphenylsulfid
3,3'-Bis-methoxymethyl-2,4'-dimethoxy-diphenylsulfid
4,4'-Bis-methoxymethyl-diphenylmethan
2,4,6-Trimethyl-1,3-bis-hydroxymethyl-benzol
4,4'-Bis-methoxymethyl-benzophenon
4,4'-Bis-acetoxymethyl-diphenylsulion
Bis-(4-hydroxy-5-methyl-3-hydroxymethyl-phenyl)sulfon

Die aus der Kondensation der aufgeführten Monomeren resultierenden Produkte sind Oligomere der oben angegebenen Formel II.

Um brauchbare Produkte zu erzielen, muß die Kondensation unter solchen Bedingungen und mit solchen Reaktionsteilnehmern durchgeführt werden, die keine unerwünschte exotherme Reaktion zulassen. Wenn bei den nachfolgend beschriebenen Vorgängen nicht sehr sorgfültig verfahren wird, kann es zu einer unkontrollierten Reaktion unter Ausbildung von Produkten mit übermäßig hohem Molekulargewicht kommen. Oligomere mit geeignetem Molekulargewicht sind im allgemeinen in dem Kondensationsmedium löslich und bilden ferner nach der Kondensation mit einem Diazomonomeren lichtempfindliche Kondensationsprodukte, die in geeigneten herkömmlichen Beschichtungslösemitteln, z. B. Butylacetat, Diisobutylketon, Pentanon, 2-Methoxy-ethanol und Dimethylformamid, löslich bleiben.

Die Kondensationsreaktionen werden normalerweise in stark sauren Medien durchgeführt. Geeignete Säuren sind z. B. $H_3PO_4$, $H_2SO_4$, HCl, HBr, $HPF_6$, $H_3PO_3$, $HBF_4$ in einer Konzentration von 70 bis 100 %. Bevorzugt werden $H_3PO_4$ und $H_2SO_4$. Wenn $H_2SO_4$ verwendet wird, so hat sie vorzugsweise eine Konzentration von 96 Gew.-%.

Die Verwendbarkeit der Säure ist von der Reaktivität des Monomeren abhängig. Normalerweise ist $H_2SO_4$ das stärkste Kondensationsmedium und sollte deshalb nur für die Monomeren mit der schwächsten Reaktivität genommen werden, für die sie dann das bevorzugte Medium darstellt.

In bestimmten Fällen kann eine zu starke Wirkung der reinen Säure durch Verdünnen mit einem nichtpolaren Lösemittel gemildert werden. Wenn z. B. 4,4'-Bis-methoxymethyl-diphenylether in unverdünnter $H_2SO_4$ umgesetzt wird, so entsteht ein unlöslicher Niederschlag in stark exothermer Reaktion, der sich auch nicht durch eine verminderte Zugabegeschwindigkeit oder durch starke Kühlung unter Kontrolle bringen läßt.

Hier und in den meisten anderen Fällen ist $H_3PO_4$ das bevorzugte Kondensationsmedium. Durch Verdünnen von 1 Teil konzentrierter $H_2SO_4$ mit 4 Teilen 1,4-Dioxan wird jedoch meistens die Bildung von unlöslichen, schwer zu kontrollierenden Niederschlägen verhindert. Es entsteht dann zwar ein brauchbares Vorkondensat, doch es ist schwierig, die gewünschte Verbindung durch Abscheiden zu erhalten, und deshalb ist der Einsatz einer anderen, unverdünnten Säure vorteilhafter. Mit z. B. 85 %-iger $H_3PO_4$ gibt es in dieser Hinsicht keine Schwierigkeit.

Manchmal werden heterocyclische aromatische Verbindungen am besten in $H_2SO_4$ umgesetzt, wogegen symmetrische aromatische Verbindungen und Alkylarylverbindungen im allgemeinen am besten in $H_3PO_4$ umgesetzt werden.

Das Mischen des zur Kondensation verwendeten Monomeren mit der Säure kann entweder durch Zugabe des Monomeren zur Säure oder durch Zugabe der Säure zum Monomeren erfolgen. In fast allen Fällen wird vorzugsweise die Säure unter starkem Rühren mit den Monomeren versetzt. Dabei muß in einigen Fällen eine Wärmeentwicklung durch Kühlen gesteuert werden.

Bei Verwendung von $H_2SO_4$ (stets unter starkem Rühren) ist die Zugabegeschwindigkeit kritischer, d. h. die Zugabe sollte tropfenweise erfolgen. Bei $H_3PO_4$ ist, unabhängig davon, ob das Monomere allmählich oder auf einmal zugegeben wird, normalerweise kein großer Unterschied im Endprodukt festzustellen.

Orthophosphorsäure, das allgemein bevorzugte Kondensationsmedium, wird in einer Konzentration von 80 bis 100 % verwendet, wobei etwa 85 % bevorzugt werden. Die Kondensationstemperatur liegt bei den verschiedenen Säuren zwischen etwa -10° C und + 70° C, vorzugsweise zwischen etwa -10° C und +50° C und am vorteilhaftesten zwischen etwa 5° C und 50° C.

Das Verhältnis zwischen Monomerem und Kondensationsäure kann 1 Gewichtsteil Monomeres zu 1 bis 4 Gewichtsteilen Säure betragen. Generell bevorzugt ist jedoch die Verwendung von 1 Gewichtsteil Monomerem auf etwa 1,5 Gewichtsteile Säure.

Durch eine längere Reaktionszeit erhöht sich die Anzahl der Monomereneinheiten in der Oligomerenkette, was zu höherer Lichtempfindlichkeit und zu allgemein geringerer Wärmebeständigkeit nach der Kondensation mit Diazomonomerem führt.

Die durchschnittliche Anzahl der Monomereneinheiten im Oligomeren soll zwischen etwa 1,5 und dem Punkt beginnender Unlöslichkeit in der Kondensationssäure liegen, vorzugsweise zwischen etwa 1,7 und 2,5.

Eine übermäßige Verlängerung der Homokondensationsreaktion führt zu unlöslichen Polymeren (höheres

Molekulargewicht als gewunscht), die sich nicht mehr für die Kondensation mit Diazomonomeren eignen.

Nachdem die Homo- oder Cokondensationsreaktion über den gewünschten Zeitraum durchgeführt worden ist, wird das Reaktionsgemisch durch Zugabe einer großen Menge Wasser verdünnt, wodurch das Reaktionsprodukt ausgefällt wird. Es wird mehrmals mit Wasser gewaschen, um die gesamte Saure zu entfernen. Das ausgefällte Produkt wird getrocknet und ist dann für die Reaktion mit dem Diazomonomeren fertig.

Brauchbare Produkte können ferner durch die Cokondensation des diazofreien Monomeren mit Formaldehyd, z. B. in Form von Paraformaldehyd, der zuerst in dem Reaktionsmedium aufgelost wird, hergestellt werden.

Zur Bestimmung der tatsächlichen Zusammensetzung eines Oligomeren aus der Homokondensation des 4,4'-Bismethoxymethyl-diphenylethers wurde eine für die Kondensation mit einem Diazomonomeren geeignete Homologenmischung fraktioniert und die einzelnen Bestandteile des Oligomeren isoliert und analysiert. Genaue Angaben hierüber sind in Beispiel 11 enthalten.

Man nimmt an, daß es dabei zwei Kondensationsarten gibt. D. h. im ersten Fall entsteht eine Methylenbrücke, wenn der aromatische Ring des zweiten Monomeren in einer anderen Stellung als der des Substituenten R'' protoniert wird. Dadurch bleibt die Gruppe R'' in ihrer Stellung, was in der Formel II durch T ausgedruckt wird. Bei der zweiten Art ist vermutlich je ein Substituent R'' der beiden Reaktionsteilnehmer an der Kondensation beteiligt, und das führt zu einer -$CH_2$-O-$CH_2$-Brücke.

Zur Herstellung von lichtempfindlichen Kondensationsprodukten wurden die einzelnen Fraktionen mit Diphenyl-amin-4-diazoniumsulfat kondensiert. Wurden diese lichtempfindlichen Kondensationsprodukte auf einen geeigneten Aluminiumträger aufgebracht, so erhöhte sich die Lichtempfindlichkeit der Beschichtung mit der Anzahl der Einheiten im Oligomeren bis zum 11-fachen (für die höchste Fraktion) der Lichtempfindlichkeit, die man erhielt, wenn man das Monomere unverändert mit dem Diazomonomeren kondensierte. Das zuletzt genannte Verfahren ist in den US-PS 3 679 419, 3 849 932 und 3 867 147 beschrieben.

Das Ergebnis der vorliegenden Erfindung ist die gewünschte Erhöhung der Lichtempfindlichkeit, die man durch eine kontrollierte Vorkondensation in der soeben beschriebenen Weise erzielt.

In Fällen, in denen größtmögliche Lichtempfindlichkeit erforderlich ist, kann diese durch die Isolierung und Verwendung eines der höheren Oligomeren erreicht werden. Im allgemeinen ist es jedoch wirtschaftlicher, das nicht fraktionierte Reaktionsgemisch zu verwenden, wodurch sich immer noch eine Erhöhung der Lichtempfindlichkeit mindestens bis zum Vierfachen gegenüber dem Stand der Technik ergibt.

Wie ersichtlich wird, gibt es drei Arten von Oligomerengemischen, die alle gemäß der Erfindung geeignet sind. Das erste Gemisch erhält man durch Homokondensation eines diazofreien Monomeren. Dabei handelt es sich um ein Gemisch aus Dimeren, Trimeren, Tetrameren usw. und deren Isomeren.

Ein zweites Gemisch erhält man durch die Kondensation von mindestens zwei verschiedenen geeigneten Monomeren. Durch diese Cokondensation bildet sich ein Gemisch von Oligomeren, die ein, zwei oder mehrere der verschiedenen Monomeren in statistischer Verteilung in derselben Kette enthalten.

Ein drittes Gemisch entsteht durch physikalisches Mischen der oligomeren Produkte aus mindestens zwei getrennt durchgeführten Homokondensations- oder Cokondensationsreaktionen.

Jedes dieser Gemische ist in dieser Erfindung von Nutzen, da in allen Fällen der Abstand zwischen den reaktiven Stellen im Vergleich zu dem ursprünglichen Monomeren erhöht worden ist, und bei der anschließenden Kondensation mit Diazomonomeren ist der Abstand zwischen den Diazogruppen entsprechend größer. Der Vorteil, den man aus dieser Erhohung der Abstände gewinnt, wird weiter unten erörtert.

Anschließend wird das oligomere Produkt in herkömmlicher Weise, z. B. gemäß US-A-3 849 392, mit einem Diazomonomeren kondensiert und nach den in dieser Patentschrift genannten Standardverfahren isoliert.

Die für die Kondensation mit den oben beschriebenen Oligomeren und Oligomerengemischen geeigneten Diazomonomeren lassen sich durch die Formel 1 darstellen.

Einzelne geeignete Diazomonomere sind z. B:

Diphenylamin-4-diazoniumsulfat
3-Methoxy-diphenylamin-4-diazoniumsulfat
3-Methoxy-diphenylamin-4-diazoniumbromid
3-Methyl-diphenylamin-4-diazoniumsulfat
3-Methyl-6-methoxy-diphenylamin-4' -diazoniumchlorid
Diphenylamin-4-diazoniumchlorid-2'-carbonsäure
4-Tolylmercapto-2,5-diethoxy-benzoldiazoniumchlorid - 1/2 $ZnCl_2$

Selbstverständlich können die oben angegebenen Anionen in den meisten Fällen ausgetauscht und durch andere Anionen ersetzt werden.

Bei der Durchführung der Kondensationsreaktion werden als Diazomonomere zum Beispiel Phosphate, Chloride, Bromide, Sulfate, Nitrate oder Fluoride eingesetzt.

Diese Monomeren sind wasserlöslich und, was wesentlich ist, in der Kondensationssäure löslich. Wenn die Reaktion unter den nachfolgend beschriebenen Bedingungen abgelaufen ist, wird sie gewöhnlich dadurch beendet, daß das Reaktionsgemisch durch Zugabe einer stark überschüssigen Wassermenge verdünnt wird. Soll das Produkt in wasserlöslicher Form isoliert werden, so wird es durch Aussalzen zurückgewonnen. Das geschieht üblicherweise durch Zugabe einer 50 %-igen Zinkchloridlösung, wie beispielsweise in US-A 3 849 392, Beispiel 1, beschrieben. Ein solches Produkt, bei dem das anfänglich vorhandene Anion erhalten bleibt, ist zum Beispiel zur Verwendung für Selbstbeschichtungsplatten geeignet.

Falls ein wasserunlösliches, in organischen Lösemitteln lösliches Produkt gewünscht wird, wird anstelle des soeben beschriebenen Aussalzens eine Säure zugesetzt, um das Kondensat, vorzugsweise in filtrierbarer Form, aus seiner wäßrigen Losung auszufällen, wobei das ursprüngliche Anion in Lösung zurückbleibt und durch das neue, die Löslichkeit im Lösemittel bewirkende Anion ersetzt wird. Zu diesem Zweck geeignete Säuren sind in US-A 3 849 392, Spalte 17, Zeilen 34 bis 50, aufgeführt, mit Ausnahme von aliphatischen Phosphonsäuren oder Methansulfonsäure. Zu diesen Säuren zählen Tetrafluoroborsäure, Hexafluorophosphorsäure, Toluolsulfonsäure, Mesitylensulfonsäure und zahlreiche weitere aromatische Sulfonsäuren, die sich als besonders geeignet erwiesen haben.

Das ausgefällte Produkt kann sofort oder nach weiterer Reinigung durch erneutes Auflösen in Lösemittel und Wiederausfällen mit Wasser verwendet werden.

Diese in Lösemittel löslichen Kondensate eignen sich sehr gut für Beschichtungsmassen, die organische Harze und andere in Lösemittel lösliche Bestandteile enthalten. Auf diese Weise können zum Beispiel vorsensibilisierte Druckplatten hergestellt werden.

Durch Verwendung eines Oligomeren, das mindestens zwei endständige, mit einem Diazomonomeren reaktionsfähige Gruppen aufweist, enthalten die entstehenden Kondensationspolymeren wiederkehrende, durch Methylengruppen verbundene Oligomeren- und Diazoeinheiten. Die Oligomereneinheiten können durch Q dargestellt werden, wobei Q eine Gruppe der Verbindung nach Formel II ist. Die Diazoeinheiten können mit $A-N_2X$ bezeichnet werden. $A-N_2X$ ist eine Gruppe der Verbindung gemäß Formel I. X kann in dieser Formel eines der oben genannten Anionen sein, einschließlich derjenigen, die dem Kondensat Wasserlöslichkeit verleihen sowie derjenigen, die Löslichkeit in organischen Lösemitteln bewirken.

Bevorzugte Diazomonomere sind 3-Methoxy-diphenylamin-4-diazoniumchlorid und 3-Ethoxy-diphenylamin-4-diazoniumchlorid und die entsprechenden Sulfate und Bromide und ferner 2,5-Diethoxy-4-tolylmercapto-benzoldiazoniumsalz als Chlorid, Bromid oder Sulfat.

Vorteilhaft werden etwa 0,8 bis 1,3, bevorzugt 0,9 bis 1,1, Mol Oligomeres mit 1 Mol Diazoniumsalzmonomerem kondensiert.

Bei $H_3PO_4$ als Kondensationsmedium liegen die Temperaturen im allgemeinen bei 20 bis 50°C und die Reaktionszeiten bei 12 bis 14 Stunden. Im Falle von $H_2SO_4$ betragen die Temperaturen etwa -5 bis 18°C und die Zeiten 10 bis 20 Stunden.

In bevorzugter Ausführung hat das Kondensationspolymere in seiner Oligomerengruppierung ein durchschnittliches Molverhältnis von 1 Diazo- zu etwa 1,7 Monomereneinheiten, wenn das ursprünglich gebildete Oligomerengemisch verwendet wird. Das ist darauf zurückzuführen, daß der Oligomerenanteil, der mit dem Diazomonomeren reagiert hat, sich aus Monomerem, Dimeren, Trimeren usw- zusammensetzt. An den aus der US-A-3 849 392 bekannten Kondensationsverbindungen wurde dieses Verhältnis analysiert und als 1:1 ermittelt, was anzeigt, daß nur Monomeres anwesend ist.

Von großer Bedeutung ist ferner der gegenuber dem Stand der Technik vergrößerte Abstand zwischen den Diazogruppen, so daß die Diazokonzentration im Molekül geringer ist. Man nimmt an, daß die Erhöhung der Lichtempfindlichkeit durch diese größeren Abstände erreicht wird.

Daraus folgt, daß die chemische Zusammensetzung oder die Identität des Oligomeren möglicherweise nicht so wichtig ist, wie die Bildung einer ausreichend langen Kette, solange das Oligomere mindestens bifunktionell ist und zur Reaktion mit einem Diazomonomeren befähigte Endgruppen enthält.

Der Abstand zwischen den Diazogruppen in den lichtempfindlichen Kondensaten soll mindestens 0,5 mm. vorzugsweise jedoch mindestens etwa 2 mm. betragen. Die obere Molekulargewichtsgrenze wird dadurch gesetzt, daß das Kondensat, wie bereits beschrieben, in den Beschichtungslösemitteln löslich sein muß. Der oben genannte Abstand wird durch den Abstand zwischen den reaktiven Stellen der im wesentlichen linearen Oligomeren mit der Struktur gemäß Formel 1 bestimmt. Allgemein haben die lichtempfindlichen Kondensate eine durchschnittliche obere Molekulargewichtsgrenze von etwa 60.000.

Bei der Kondensation soll das Verhältnis von Oligomerem bzw. Oligomerengemisch zu Diazomonomerem in etwa äquimolar sein, so wie es bei der Bildung von Kondensationspolymeren üblich ist.

Die Wärmebeständigkeit läßt sich bekanntlich durch Zugabe von Phosphorsäure, Zitronensäure oder Weinsäure in einer Menge von weniger als etwa 0,1 % verbessern.

Die nach dieser Erfindung hergestellten lichtempfindlichen Diazoniumsalze können in herkömmlicher Weise in Aufzeichnungsschichten verwendet werden. Sie können in Wasser oder Lösemitteln aufgelöst und auf Trägermaterialien aufgetragen werden und ergeben so Druckplatten, Farbprüffolien, Resists für gedruckte Schaltungen und dergl.

Die Träger können zum Beispiel aus aufgerauhtem Aluminium, transparenten Plastikfolien, Papier, Kupfer usw. bestehen.

In der Schicht können auch weitere bekannte Zusätze enthalten sein, z. B. Pigmente, Farbstoffe, polymere Bindemittel, Weichmacher, Netzmittel, Sensibilisatoren, Indikatoren usw. Solche Zusätze sind in der US-A-3 679 419, Spalte 6 ff. im einzelnen aufgeführt.

Alle Zusätze sollen selbstverständlich so ausgewählt werden, daß sie mit den Diazokondensaten verträglich sind und in dem für die Lichtzersetzung der Diazoverbindungen in Frage kommenden Wellenlängenbereich möglichst wenig Licht absorbieren. Zur Festigung des Bildes werden wasserunlösliche Polymere als Bindemittel verwendet. In Wasser oder wäßrig-alkalischen Lösungen lösliche Bindemittel werden genommen, um die Entwickelbarkeit von Aufzeichnungsschichten zu verbessern, und in Farbprüffolien und Druckplatten können sie zur Festigung des Bildes dienen. Die in Wasser löslichen oder unlöslichen Polymeren werden

normalerweise in Mengen zwischen 1 und 20 Gewichtsteilen pro Gewichtsteil Diazoverbindung zugesetzt, vorzugsweise höchstens 10 Gewichtsteile.

Wenn Pigmente in Verbindung mit Polymeren verwendet werden, werden sie in Mengen zwischen 1 und 50 Gewichtsprozent, bezogen auf das Gewicht des Polymeren, zugegeben.

Weichmacher, Farbstoffe, Netzmittel, Sensibilisatoren und Indikatoren werden den Aufzeichnungsschichten in Mengen von 0,1 bis 20 %, vorzugsweise höchstens 10 %, bezogen auf das Gewicht der anderen Schichtbestandteile, zugesetzt.

Den Aufzeichnungsschichten mit den neuen Diazokondensaten können bekannte lichtempfindliche Systeme zugesetzt werden, wie z. B. die Formaldehydkondensate von gegebenenfalls substituiertem 4-Diazodiphenylamin und die Mischkondensate gemäß US-A-3 679 419, US-A-3 849 392 und US-A-3 867 147.

Geeignete Beschichtungslösemittel sind in der US-A-3 849 392 aufgeführt. Dazu gehören u. a. die bereits genannten Butylacetat, Diisobutylketon, Pentanon, 2-Methoxyethanol und Dimethylformamid, die in erster Linie dann anwendbar sind, wenn die lichtempfindlichen Kondensate mit Anionen isoliert werden, die zur Löslichkeit in Lösemittel führen, z. B. $BF_4$, $PF_5$ und zahlreiche bereits erwähnte aromatische fonate.

Ferner sind für diesen Zweck Lösemittel wie Dioxan, Tetrahydrofuran, Bthylenglykolmonomethyletheracetat und Cyclohexanon brauchbar.

Lösemittel für Kondensate, die mit wasserlöslichen Anionen isoliert wurden, sind natürlich Wasser sowie niedere aliphatische Alkohole und andere mit Wasser mischbare Lösemittel. Zu diesen Anionen zählen das Chlorid, Bromid, Sulfat und Phosphat.

Die Aufzeichnungsmaterialien können unmittelbar nach ihrer Herstellung oder zu einem späteren Zeitpunkt verwendet werden. Es empfiehlt sich, sie an einem kühlen, trockenen Ort aufzubewahren.

Zur Weiterverarbeitung wird das Aufzeichnungsmaterial bildmäßig belichtet. Dazu kann jede für Aufzeichnungszwecke übliche Lichtquelle genommen werden, die im langwelligen UV und im kurzwelligen sichtbaren Spektralbereich emittiert.

Laser sind besonders gut geeignet, und wenn sie mit Computeranlagen und Vorrichtungen zur Strahlmodulation gekoppelt sind, ermöglichen sie eine direkte Belichtung von Druckplatten, ohne daß Zwischennegative in Originalgröße und Klebeumbrüche hergestellt werden müssen. Dadurch sind erhebliche Einsparungen beim Verfahren möglich. Die belichteten Platten werden automatisch zu Verarbeitungsmaschinen transportiert, wo sie entwickelt, fertiggestellt, getrocknet und umgebogen werden.

Der schwache Punkt ist bisher die geringe Lichtempfindlichkeit der hauptsächlich auf Diazo basierenden lichtempfindlichen Beschichtung gewesen, Die durch diese Erfindung erzielte erhöhte Lichtempfindlichkeit ist ein großer Schritt in Richtung auf die vollständige Automatisierung des Verfahrens zur Herstellung von Druckplatten mit Laserbelichtung.

Für die Belichtung von Offsetdruckplatten eingesetzte energiereiche Laser sind z. B. Argonionen-, Krypton- und Kohlendioxidlaser.

Die Wirtschaftlichkeit der Laserausrüstung ist von der hohen Lichtempfindlichkeit der zur Verfügung stehenden Platte abhängig. Die bekannten (lichtempfindlichen) Systeme benötigen eine Belichtungsenergie von 12 bis 14 $mJ/cm^2$ und sogar 25 $mJ/cm^2$, wenn eine Platte gut belichtet werden soll, wobei allerdings gleichzeitig die Lebensdauer des Lasers verkürzt wird. Bei der vorliegenden Erfindung kann mit nur 4 $mJ/cm^2$ eine ausreichende Belichtung erreicht werden.

Wenn mit herkömmlichen Lichtquellen gearbeitet wird, wird die Lichtempfindlichkeit durch Belichten einer beschichteten Platte durch einen 21-stufigen Stauffer-Stufenkeil bewertet. Bei diesem Stufenkeil handelt es sich um eine Transparentvorlage, bei der jede Stufe um das 1,414-fache ($\sqrt{2}$) dichter ist als die vorhergehende Stufe, so daß zum Beispiel die dritte Stufe doppelt so dicht ist wie die erste Stufe.

Nach dem Entwickeln und Einfärben der belichteten Platte können vergleichende Bewertungen der Lichtempfindlichkeit durchgeführt werden. Diese stehen in Beziehung zum Energiebedarf bei der Laserbelichtung. Das Bild des Stufenkeils auf der Platte zeigt eine Folge von Graustufen, die bis zum dichten Schwarz an einem Ende führen und am anderen Ende der Stufeneinteilung mit einem so schwachen Grau beginnen, daß keine Stufe mehr zu erkennen ist. Da die Stufen auf der Transparentvorlage fortlaufend numeriert sind, ist eine Ablesung möglich, die zum Beispiel 5 gleichmäßig geschwärzte und 3 teilweise gedeckte Keilstufen ergibt. Die Anzahl der gleichmäßig geschwärzten Stufen wird nur im Vergleich mit einer anderen, in gleicher Weise belichteten und entwickelten Platte interpretiert, die zum Beispiel 7 gleichmäßig geschwärzte und 4 teilgedeckte Keilstufen aufweist. In diesem Fall ist die Lichtempfindlichkeit der zweiten Platte doppelt so hoch wie die der ersten Platte ($\sqrt{2} \times \sqrt{2}$), und der Tonwertumfang von jeweils 3 Stufen zeigt einen mäßigen Kontrast.

Nach dem Belichten wird mit einem geeigneten Entwickler entwickelt. Geeignete Entwickler sind beispielsweise Wasser, Mischungen von Wasser mit organischen Lösemitteln, wäßrige Salzlösungen, wäßrige Lösungen von Säuren, z.B. von Phosphorsäure, denen Salze oder organische Lösemittel zugesetzt werden können, oder alkalische Entwickler, z.B.wäßrige Lösungen von Natriumsalzen der Phosphorsäure oder Kieselsäure. Diese Entwickler können auch mit organischen Lösemitteln versetzt werden. In einigen Fällen ist es sogar möglich, mit unverdünnten organischen Lösemitteln zu entwickeln. Die Entwickler können als weitere Bestandteile z. B. Netzmittel und Hydrophilierungsmittel enthalten.

Entwickelt wird in bekannter Weise, zum Beispiel durch Eintauchen, Überwischen oder Sprühen mit der Entwicklerflüssigkeit.

Je nach Schichtzusammensetzung, Trägermaterial und Verarbeitungsweise können mit den neuen

Diazokondensaten Einzelkopien, Reliefbilder, Gerbbilder, Druckplatten für Hochdruck, Tiefdruck und Flachdruck oder gedruckte Schaltungen hergestellt werden.

In den folgenden Beispielen sind bevorzugte Ausführungen der Erfindung beschrieben.

Wenn nichts anderes angegeben ist, sind Prozentangaben in Gewichtsprozent zu verstehen. Gewichtsteile und Volumenteile verhalten sich zueinander wie g zu $cm^3$. Alle Temperaturen sind in Grad Celsius angegeben.

**Beispiel 1**

Zur Herstellung eines diazofreien Oligomeren wurden 32,2 g Schwefelsäure (96 %) portionsweise mit 25,7 g 1,4-Dimethylol-benzol-Monomerem versetzt, wobei eine gleichbleibende Temperatur von 20°C gehalten und kräftig gerührt wurde. Nach beendeter Zugabe des Monomeren zu der Säure wurde die entstandene Aufschlämmung bei weiterem Rühren und konstanter Temperatur 1 1/2 Stunden gealtert. Im Anschluß an die Alterung wurden ungefähr 0,2 g der Oligomerenaufschlämmung abgenommen und für einen nachfolgend beschriebenen Versuch beiseite gestellt. Das gealterte Gemisch aus Oligomerem und Säure wurde in eine Lösung von 18,8 g 4-Diazodiphenylamin-sulfat in 96,5 g Schwefelsäure gegeben. Die Zugabe erfolgte langsam, d. h. über einen Zeitraum von zwei Stunden bei einer gleichbleibenden Temperatur von 20°C und unter sorgfaltigem Rühren. Nach der Zugabe ließ man das ganze Gemisch unter den zuvor beschriebenen Bedingungen 16 Stunden altern.

Das Reaktionsgemisch wurde in 3,5 l Wasser aufgelöst und als wasserunlösliches Tetrafluoroborat ausgefällt. Das entstandene Produkt wurde im Vakuum filtriert und gründlich gewaschen, um die gesamte restliche Säure zu entfernen. Es wurde dann im Vakuum getrocknet, um nahezu alle Feuchtigkeit zu beseitigen.

Das getrocknete Diazopolymere wurde in Form einer 1,0 %igen Lösung in 2-Methoxyethanol auf eine Platte aufgetragen. Das Trägermaterial bestand aus mechanisch aufgerauhtem, anodisch oxidiertem und durch Eintauchen in heiße wäßrige Polyvinylphosphonsäure hydrophiliertem Aluminium. Nach dem Trocknen hatte die auf den Träger aufgebrachte Beschichtung ein Gewicht von 115 $mg/m^2$. Die Platte wurde durch eine Negativvorlage mit aktinischer Strahlung belichtet, so daß eine Energie entsprechend 15,0 $mJ/cm^2$ auf sie auftraf. Die belichtete Platte wurde subtraktiv entwickelt und mit Druckfarbe eingefärbt. Bei der Belichtung unter dem 21-stufigen Stauffer-Stufenkeil stellte man 4 1/2 gleichmäßig geschwärzte und 3 angedeutete Keilstufen fest.

Eine weitere Platte wurde wie oben beschrieben hergestellt, jedoch nicht belichtet. Sie wurde in Abschnitte zerlegt und zum Altern in einen auf 100°C aufgeheizten Trockenschrank gelegt. Alle 15 Minuten wurden Proben entnommen, die dann entwickelt und eingefärbt wurden. Eine Platte gilt solange als gut, wie ihr Hintergrund frei von Farbe bleibt. Bei dem Diazoprodukt dieses Beispiels war die Alterung der Platte über einen Zeitraum von 150 Minuten zufriedenstellend.

Anschließend wurde das Oligomerengemisch, das noch nicht mit der Diazoverbindung kondensiert worden war, nach dem Verfahren der Standard-Dunnschichtchromatographie (DC) analysiert. Bei diesem Verfahren wird das Produkt, das vermutlich ein Gemisch ist, aufgelöst und die Lösung auf einen adsorbierenden Feststoff, z. B. auf eine Kieselgel-Platte aufgetropft. Nach dem Verdunsten des Lösemittels wird die Platte in eine Kammer eingelegt und einem "Entwickler", d. h. Dämpfen eines Lösemittels, ausgesetzt. Unter der Einwirkung des Entwicklers entfernen sich die Bestandteile des Gemischs umgekehrt proportional zu ihrem Molekulargewicht aus ihrer ursprünglichen Position. Ablauf und Ergebnisse lassen sich unter UV-Licht von 254 nm beobachten.

In diesem Fall war das ursprüngliche Lösemittel Ethylacetüt, und der Entwickler bestand aus einer Mischung von Ethylacetat und Hexanisomeren (20: 80 Volumteile).

Bei dem Versuch wurde zunächst das beiseite gestellte weiße Ausfällungsprodukt in Ethylacetat aufgelöst und durch Kapillaren auf eine DC-Platte aufgetropft. Zum Vergleich wurde daneben reines 1,4-Dimethylol-benzol aufgetropft.

Nach dem Entwickeln ergaben sich dem Reaktionsgemisch entsprechend sieben Flecken, die gewandert waren und ein Flecken, der am Ausgangspunkt geblieben war. Das reine Monomere wanderte ebenso weit wie der am weitesten entfernte Flecken des Reaktionsgemischs. Die einzelnen Flecken wurden als Monomeres, Dimere, Trimere, Tetramere usw. interpretiert. Diese qualitative Trennung und die Beobachtung finden in Beispiel 11 eine quantitative Bestätigung, in dem größere Mengen aufgetrennt und analysiert wurden.

**Beispiel 2 (Vergleichsbeispiel)**

Mit den gleichen Bestandteilen wie in Beispiel 1 wurde ein Diazoprodukt durch Zugabe von 25,7 g 1,4-Dimethylol-benzol zu einer Lösung aus 18,9 g 4-Diazo-diphenylaminsulfat in 128,7 g Schwefelsäure (96 %) ohne den Schritt der Vorkondensation hergestellt. Die monomere Substanz wurde langsam, d. h. über einen Zeitraum von zwei Stunden zugegeben, wobei ständig gerührt und die Temperatur auf 20°C gehalten wurde. Nach beendeter Zugabe wurde das Gemisch 16 Stunden gealtert. Im Anschluß an die Alterung wurde das Reaktionsgemisch in 3,5 l Wasser aufgelöst und als wasserunlösliches Tetrafluoroborat ausgefällt. Das

entstandene Produkt wurde im Vakuum filtriert und gründlich gewaschen, um die restliche Säure vollständig zu entfernen. Zur Beseitigung von nahezu der gesamten Feuchtigkeit wurde das Produkt dann im Vakuum getrocknet.

Wie in Beispiel 1 beschrieben, wurden Platten hergestellt, an denen Belichtung und Alterung geprüft werden sollten.

Eine Platte mit einem Beschichtungsgewicht von 112 mg/m$^2$, die mit 15,0 mJ/ m$^2$ belichtet worden war, zeigte 1/2 gleichmäßig geschwärzte und 2 angedeutete Keilstufen und somit ein Viertel der Lichtempfindlichkeit des Produktes aus Beispiel 1. Das Ergebnis der Alterung bei 100°C war bis zu 165 Minuten gut. Dieses Beispiel ist repräsentativ für Produkte nach dem Stand der Technik gemäß US-A-3 867 147.

**Beispiel 3**

31,7 g 4,4'-Bis-methoxymethyl-benzil wurden als Homokondensat in 48,0 g Schwefelsäure (96 %) vorkondensiert. Dabei wurde das Benzilmonomere über einen Zeitraum von 1 Stunde zu der Säure gegeben und 4 Stunden gealtert. Nach dem Altern wurde die Aufschlämmung einer Lösung aus 18,6 g 4-Diazo-diphenylaminsulfat in 144,0 g Schwefelsäure zugesetzt, wobei eine Temperatur von 8°C gehalten und ständig gerührt wurde. Es folgte eine 18-stündige Alterung des Gemisches bei gleichbleibender Temperatur, wonach das Gemisch in 3,5 l Wasser aufgelöst und dann als Hexafluorophosphat ausgefällt wurde. Das Produkt wurde im Vakuum filtriert und gut gewaschen und danach nahezu die gesamte Feuchtigkeit durch Trocknen im Vakuum daraus entfernt. Das getrocknete Produkt wurde wie im Beispiel 1 beschrieben geprüft. Es zeigten sich 6 1/2 gleichmäßig geschwärzte und 3 angedeutete Keilstufen. Die Alterung bei 100°C brachte bis 150 Minuten gute Ergebnisse.

Eine Probe des Homokondensats wurde durch Dünnschichtchromatographie entsprechend Beispiel 1 weiter ausgewertet. Es zeigte sich, daß der größte Teil des Monomeren zu 7 Oligomeren (einschließlich Monomerem) und einer bestimmten Menge an nicht-wandernden Produkten umgesetzt worden war.

**Beispiel 4 (Vergleichsbeispiel)**

31,7 g 4,4'-Bis-methoxymethyl-benzil wurden ohne Vorkondensation unter ständigem Rühren und bei gleichbleibender Temperatur von 8°C direkt in eine Lösung aus 18,6 g 4-Diazo-diphenylaminsulfat und 192,0 g Schwefelsäure (96 %) gegeben. Nach 18-stündiger Alterung wurde das Gemisch in 3,5 l Wasser aufgelöst und als Hexafluorophosphat ausgefällt. Im Anschluß an das Absaugen wurde das Produkt getrocknet, bis nahezu die gesamte Feuchtigkeit daraus entfernt war. Das getrocknete Produkt wurde wie in Beispiel 1 beschrieben geprüft. Eine belichtete Platte zeigte 3/4 einer gleichmäßig geschwärzten Keilstufe und zwei angedeutete Keilstufen, bzw. 1/8 der Lichtempfindlichkeit des Produktes aus Beispiel 3. Das Ergebnis der Alterung bei 100°C war bis zu 165 Minuten gut.

**Beispiel 5**

3,7 g Paraformaldehyd wurden unter ständigem Rühren bei 8°C in 48,0 g Schwefelsäure (96 %) aufgelöst. Zu der Lösung wurden dann noch 31,7 g 4,4'-Bis-methoxymethyl-benzil langsam zugegeben, wobei kräftig gerührt wurde. Man ließ diese Aufschlämmung 2 Stunden altern. Nach dem Altern wurde das Reaktionsgemisch in eine Lösung aus 192,0 g Schwefelsäure und 18,6 g 4-Diazo-diphenylamin-sulfat gegeben. Während der Zugabe wurde ständig gerührt und die Temperatur auf 8°C gehalten. Das Gemisch wurde dann 14 Stunden gealtert und anschließend in zwei gleiche Teile geteilt. Jede Hälfte wurde in 2,0 l Wasser gegeben. Eine der beiden Hälften wurde als Hexafluorophosphat ausgefällt, gefiltert und getrocknet, während die andere Hälfte als das wasserlösliche Chlorozinkat ausgefällt wurde. Dieses zweite Produkt wurde gleichfalls gefiltert und getrocknet.

Aus der Hexafluorophosphat-Diazoverbindung wurde nach ausreichendem Trocknen eine 1,0 %ige Lösung in 2-Methoxy-ethanol hergestellt, die gemäß Beispiel 1 geprüft wurde. Die verarbeitete Platte hatte 8 gleichmäßig geschwärzte und 3 angedeutete Keilstufen bzw. eine nahezu doppelt so hohe Lichtempfindlichkeit wie das Produkt aus Beispiel 3. Aus dem Zinkchlorid-Diazosalz wurde eine 1,0 %ige Lösung in vollentsalztem Wasser hergestellt und gleichfalls geprüft. Die entstandene Platte zeigte 8 gleichmäßig geschwärzte und 3 angedeutete Keilstufen. Beide Platten ließen sich etwas weniger als 60 Minuten bei 100°C altern, wobei die Hexafluorophosphatverbindung etwas besser war als die Zinkchloridverbindung.

Vor der Kondensationsreaktion mit dem Diazomonomeren wurde das vorkondensierte Co-Oligomere (auf eine Testplatte) aufgetropft und wie in Beispiel 1 beschrieben dünnschichtchromatographisch geprüft. Das Oligomere ließ sich in 16 Bestandteile auftrennen. Es blieb kaum eine Spur von Monomerem neben einer großen Menge an nicht-wandernden Produkten, was darauf schließen ließ, daß sich außer einer großen Anzahl von Isomeren auch eine Erhöhung des Molekulargewichts ergeben hatte.

**Beispiel 6 (Vergleichsbeispiel)**

89,3 g Phosphorsäure (85 %), die bereits 18,2 g 3-Methoxy-4-diazo-diphenylaminsulfat enthielt, wurde allmählich mit 28,2 g 1,4-Bis-(2-hydroxy-prop-2-yl)benzol versetzt. Während der Zugabe wurde das Gemisch gut gerührt und auf 40°C gehalten. Nach beendeter Zugabe wurde das Reaktionsgemisch 16 Stunden gealtert und anschließend in 4,0 l Wasser eingegehen. Das Produkt wurde als Tetrafluoroborat ausgefüllt. Die Verbindung wurde filtriert und gut getrocknet. Sie wurde dann als 1,0 %ige Lösung in 2-Methoxy-ethanol wie in Beispiel 1 beschrieben auf ihre Funktionsfähigkeit geprüft. Nach dem Belichten und Entwickeln hatte die Platte 1/2 gleichmäßig geschwärzte und 1 1/2 angedeutete Keilstufen bzw. 1/4 der Lichtempfindlichkeit des Produktes aus Beispiel 1. Die Platten ließen sich bei 100°C bis zu 210 Minuten gut altern.

**Beispiel 7 (Vergleichsbeispiel)**

3,8 g Paraformaldehyd wurden über einen Zeitraum von 2 1/2 Stunden in eine Lösung aus 18,2 g 3-Methoxy-4-diazo-diphenylaminsulfat in 89,3 g Phosphorsäure (85 %) gegeben. Während der Zugabe und im Verlauf des nachfolgenden 16-stün-digen Alterungsprozesses wurde das Gemisch unter kräftigem Rühren auf 40°C gehalten. Danach wurde das Reaktionsgemisch in 4,0 l Wasser gegeben. Das Diazoprodukt wurde als Tetrafluoroborat ausgefällt. Die Verbindung wurde abfiltriert und gut getrocknet. Als 1,0 %ige Lösung in 2-Methoxyethanol wurde das Diazoprodukt gemäß Beispiel 1 auf seine Funktionsfähigkeit geprüft. Nach dem Belichten und Entwickeln zeigte die Platte 1/4 einer gleichmäßig geschwärzten Stufe und eine angedeutete Stufe. Die Platten ließsen sich bei 100°C bis zu 240 Minuten gut altern.

**Beispiel 8**

3,8 g Paraformaldehyd wurden bis zum vollständigen Auflösen langsam in 30,0 g Phosphorsäure (85 %) gegeben. Unter kräftigem Rühren und bei einer konstanten Temperatur von 40°C wurde die Lösung aus Paraformaldehyd und Säure allmählich mit 28,2 g 1,4-Bis-(2-hydroxy-prop-2-yl)benzol versetzt. Man ließ das Gemisch 2 Stunden altern und gab es danach unter starkem Rühren bei 40°C langsam in eine Lösung aus 59,3 g Phosphorsäure und 18,2 g 3-Methoxy-4-diazo-diphenylaminsulfat.

Nach 16-stündigem Altern wurde das Reaktionsgemisch in 4,0 l Wasser gegeben und anschließend als Tetrafluoroborat ausgefällt. Die Verbindung wurde abfiltriert und getrocknet. Als 1,0 %ige Lösung in 2-Methoxyethanol wurde das Diazosalz gemäß Beispiel 1 auf seine Funktionsfähigkeit geprüft. Nach dem Belichten und Entwickeln hatte die Platte 8 gleichmäßig geschwärzte und 3 angedeutete Stufen. Bei 100°C ließ sie sich bis zu 165 Minuten gut altern.

Wie in Beispiel 1 wurde das Vorkondensat dünnschichtchromatographisch geprüft. Nach dem Wandern des Lösemittels wurde die Kieselgelplatte unter UV-Licht betrachtet. 13 Bestandteile ließen sich deutlich unterscheiden, wobei sehr wenig Monomeres vorhanden war. Es war ein großer Anteil an Rückstand vorhanden, der nicht gewandert war.

**Beispiel 9**

30,0 g Phosphorsäure (85 %) wurden unter starkem Rühren bei 40°C langsam mit 28,2 g 1,4-Bis-(2-hydroxy-prop-2-yl) benzol versetzt. Im Gegensatz zu Beispiel 6 wurde das Monomere zur Bildung eines Oligomeren zunächst mit sich selbst vorkondensiert. Nach 2-stündigem Altern setzte man das Vorkondensat allmählich einer Lösung aus 12,2 g 3-Methoxy-4-diazo-diphenylaminsulfat und 59,3 g Phosphorsäure zu, die unter starkem Rühren gleichfalls auf 40°C gehalten wurde. Im Anschluß an eine 16-stündige Alterung gab man das Reaktionsgemisch in 4,0 l Wasser und fällte es dann als Tetrafluoroborat aus. Die Verbindung wurde abfiltriert und gut getrocknet. Als 1,0 %ige Lösung in 2-Methoxyethanol wurde das Diazoprodukt wie in Beispiel 1 beschrieben auf seine Funktionsfähigkeit geprüft. Nach dem Belichten und Entlickeln zeigte die Platte 51/2 gleichmäßig geschwärzte Stufen und 2 angedeutete Stufen. Bei 100°C ließ sie sich bis zu 255 Minuten gut altern.

Bei der Dünnschichtchromatographie des Vorkondensats vor der Zugabe zu der Lösung aus Diazoverbindung und Säure zeigte die Probe unter UV-Licht 8 Flecken mit einem mäßigen Anteil an Rückstand, der nicht gewandert war. Daneben war auch ein mäßiger Anteil an nicht umgesetztem Monomerem anwesend.

**Beispiel 10 (Vergleichsbeispiel)**

32,2 g 3-Methoxy-4-diazo-diphenylaminsulfat wurden in 142 g Phosphorsäure (85 %) gelöst und bei kräftigem Rühren auf 40°C gehalten. Dieser Lösung wurden allmählich 25,8 g 4,4'-Bis-methoxymethyl-diphenylether zugesetzt. Nach beendeter Zugabe ließ man das Reaktionsgemisch 17 Stunden altern und löste es dann in 3,5 l Wasser auf.

Das Produkt wurde als Mesitylensulfonat ausgefällt und das ausgefällte Produkt abfiltriert und gut getrocknet. Als 1,0 %ige Lösung in 2-Methoxyethanol wurde das Diazoprodukt wie im Beispiel 1 auf seine Funktionsfähigkeit geprüft. Nach dem Belichten und Entwickeln hatte die Platte 2 gleichmäßig geschwärzte Stufen und 2 angedeutete Stufen, und sie ließ sich bei 100°C bis zu 270 Minuten altern.

**Beispiel 11**

43,9 g 4,4'-Bis-methoxymethyl-diphenylether wurden langsam in 35,5 g Phosphorsäure (85 %) gegeben und unter ständigem Rühren 2 Stunden bei Raumtemperatur gealtert. Im Anschluß an das Altern setzte man das Vorkondensat langsam einer Lösung aus 32,2 g 3-Methoxy-4-diazo-diphenylaminsulfat in 106,5 g Phosphorsäure zu, die gut gerührt und auf 40°C gehalten wurde. Nach beendeter Zugabe ließ man das Reaktionsgemisch 17 Stunden altern und löste es dann in 3,5 l Wasser auf. Das Diazoprodukt wurde als Mesitylensulfonat ausgefällt und dann abfiltriert und gut getrocknet. Als 1,0 %ige Lösung in 2-Methoxyethanol wurde das Diazoprodukt wie in Beispiel 1 beschrieben auf seine Funktionsfähigkeit geprüft. Nach dem Belichten und Entwickeln hatte die Platte 7 1/2 gleichmäßig geschwärzte Stufen und weitere angedeutete Keilstufen. Sie ließ sich bei 100°C bis zu 180 Minuten altern.

Bei der Dünnschichtchromatographie entsprechend Beispiel 1 ermittelte man unter UV-Licht 9 Komponenten. Es zeigte sich ein beträchtlicher Anteil an Monomerem neben einigen hochmolekularen Homologen, die nicht wanderten.

Es wird vermutet, daß die Komponenten Oligomere waren, die als Ergebnis einer steigenden Anzahl von reagierenden Monomereneinheiten ein zunehmendes Molekulargewicht aufwiesen. Um diese Hypothese zu bestätigen und die chemische Struktur näher zu identifizieren, wandte man die Hochleistungs-Flüssigchromatographie (HPLC), die präparative Flüssigchromatographie (PLC) und die Kernresonanzmessung (NMR) an. Bei der HPLC wurde das Vorkondensat von 4,4'-Bis-methoxy-methyl-diphenylether vor dem Zugeben zu der Diazoverbindung, jedoch nach dem Altern, aufgetrennt. Während die DC 9 wandernde Oligomere zeigte, wies die HPLC 11 davon auf. Eine Probe von 7 1/2 g des Vorkondensats wurde in 500 ml Ethylacetat aufgelöst, welches dann zum Beschicken einer Kieselgel-Trennsäule verwendet wurde. Die Säule wurde in einen Druckbehälter eingeschlossen, und man leitete ein unter Druck stehendes Gemisch aus Ethylacetat und Hexanisomeren (20: 80 Volumenteile) durch die Säule. Während das Elutionsmittel durch das Kieselgel lief, wanderten die Isomeren mit dem niedrigsten Molekulargewicht am schnellsten, und auf diese Weise wurde die Auftrennung bewirkt. Mit einer UV-Lichtquelle als Sensor wurde die Auftrennung in die einzelnen Fraktionen beobachtet. Man fing jede Fraktion einzeln auf und behandelte sie im Rotationsverdampfer. Dabei wurde das Lösemittel entfernt, und es blieb nur der reine Extrakt zurück. Jeder Extrakt wurde dann durch eine Kernresonanzmessung (NMR) analysiert und so seine Struktur identifiziert. Die Ergebnisse von PLC und NMR sind in der folgenden Tabelle aufgeführt:

| Fraktion | Gew.-% | Menge in g* | Beschreibung aufgrund der NMR | |
|---|---|---|---|---|
| | | | Produkt | Y-Brücke |
| 1 | 25,0 | 1,525 | Monomeres | --- |
| 2 | 5,6 | 0,342 | Dimeres | Dimethylenether |
| 3 | 9,4 | 0,573 | Dimeres | Methylen |
| 4 | 9,8 | 0,593 | Trimeres | Methylen |
| 5 | 17,7 | 1,080 | Trimeres | sowohl Methylen als auch Dimethylenether |
| 6 | 13,5 | 0,824 | Trimeres | wie 5, jedoch mit endständigem -OH |
| 7 | 19,0 | 1,158 | Tetrameres und höher | |

* Von den ursprünglich eingesetzten 7,6 g lösten sich 1,5 g nicht auf und wurden deshalb bei der PLC nicht aufgetrennt, sondern vor dem Einfüllen in den Druckbehälter abfiltriert. Die Prozentangaben und Mengen beziehen sich also nur auf die als Fraktionen zurückgewonnenen 6,1 g.

Jede Fraktion wurde im Molverhältnis 1: 1 mit 4-Diazo-diphenylaminsulfat umgesetzt. Die Kondensationsreaktion fand in 85 %iger Phosphorsäure bei 40° C statt.

Man ließ das Reaktionsgemisch in jedem Fall unter ständigem Rühren 17 Stunden altern. Nach Ablauf dieser Zeit wurde das Diazoprodukt in 200 ml Wasser aufgelöst und als Tetrafluoroborat ausgefällt. Das ausgefällte Produkt wurde abfiltriert und getrocknet und dann wie in Beispiel 1 geprüft. Die Ergebnisse sind wie folgt:

| Fraktion | gleichmäßig geschwärzte Stufen | angedeutete Stufen |
|---|---|---|
| 1 | 3 | 2 |
| 2 | 5 1/2 | 3 |
| 3 | 5 | 3 |
| 4 | 7 | 3 |
| 5 | 7 1/2 | 3 |
| 6 | 7 1/2 | 3 |
| 7 | 10 | 4 |

Diese Ergebnisse zeigen, daß die Lichtempfindlichkeit von der langsamsten (Fraktion 1) bis zur schnellsten (Fraktion 7) Fraktion etwa um das 9-fache zunimmt.

**Beispiele 12 bis 26**

Nach dem unten angegebenen Schlüssel sind weitere Daten tabellarisch aufgeführt, wodurch verschiedene Kondensationsmonomere, Diazomonomere, Anionen und Kondensationsmedien miteinander verglichen werden.

Die Funktionsprüfung wurde entsprechend Beispiel 1 durchgeführt. Die Reaktionsbedingungen lagen im Rahmen der vorhergehenden Beispiele.

**Diazomonomere**

D-1 4-Diazo-diphenylaminsulfat
D-2 3-Methoxy-4-diazo-diphenylaminsulfat
D-3 3-Methoxy-4-diazo-diphenylaminchlorid
D-4 2,5-Diethoxy-4-diazo-(tolylmercapto)-benzol - 1/2 $ZnCl_2$
D-5 2,5-Dibutoxy-4-diazo-(tolylmercapto)-benzol. 1/2 $ZnCl_2$

**Kondensationsmonomere**

R-1 Styrol/Butadien-Copolymeres mit endständigen Hydroxygruppen
R-2 3,3'-Bis-(methoxymethyl)benzidin
R-3 4,4'-Bis-(methoxymethyl)diphenylether
R-4 2,2'-Bis-(4-hydroxymethyl-phenyl)propan
R-5 Paraformaldehyd
R-6 4,4'-Bis-acetoxymethyl-diphenylmethan

**Anionen**

(des isolierten Diazo-Kondensationsprodukts)
X-1 Tetrafluoroborat
X-2 Hexafluorophosphat
X-3 Paratoluolsulfonat
X-4 Mesitylensulfonat
X-5 Chlorid

In den folgenden Beispielen bedeutet das Sternchen, daß keine Vorkondensation durchgeführt wurde, sondern daß das Monomere als solches zugegehen wurde, wie bei den aus dem Stand der Technik bekannten Reaktionen ($H_3PO_4$ wurde als 85 %ige, $H_2SO_4$ als 96 %ige wäßrige Lösung eingesetzt):

| Beispiel | Diazo-monomeres | Kondensations-monomeres | Anion | Säure | gleichm. geschwärzte Stufen | angedeutete Stufen |
|---|---|---|---|---|---|---|
| 12 | D-1 | R-5* | X-1 | $H_3PO_4$ | 1 1/2 | 2 |
| 13 | D-1 | R-3+R-5 | X-1 | $H_3PO_4$ | 12 | 4 |
| 14 | D-1 | R-3 | X-1 | $H_3PO_4$ | 9 | 3 |
| 15 | D-2 | R-5* | X-2 | $H_3PO_4$ | 1 | 2 |
| 16 | D-2 | R-5+R-3 | X-2 | $H_3PO_4$ | 11 | 4 |
| 17 | D-3 | R-6* | X-5 | $H_3PO_4$ | 2 | 2 |
| 18 | D-3 | R-6 | X-5 | $H_3PO_4$ | 7 | 3 |
| 19 | D-1 | R-1 | X-5 | $H_2SO_4$ | 1/4 | 2 |
| 20 | D-1 | R-1 | X-5 | $H_2SO_4$ | 3 | 3 |
| 21 | D-2 | R-2* | X-4 | $H_3PO_4$ | kein Bild | |
| 22 | D-2 | R-2 | X-4 | $H_3PO_4$ | 1 | 2 |
| 23 | D-4 | R-3* | X-3 | $H_2SO_4$ | 2 | 3 |
| 24 | D-4 | R-3 | X-3 | $H_2SO_4$ | 6 | 3 |
| 25 | D-5 | R-4* | X-2 | $H_3PO_4$ | 3/4 | 2 |
| 26 | D-5 | R-4 | X-2 | $H_3PO_4$ | 5 | 3 |

Die anhand der Beispiele ermittelten Daten zeigen, daß eine Vorkondensation zu Oligomeren, gefolgt von einer Kondensation mit Diazomonomerem zu Aufzeichnungsschichten führt, die eine höhere Lichtempfindlichkeit haben als ohne eine solche Vorkondensation. Weiterhin ergibt sich in vielen Fällen eine Verbesserung um das 4-fache, wenn ein rohes Reaktionsgemisch aus Oligomeren verwendet wird. Werden jedoch einzelne höhere Oligomere aufgetrennt und mit Diazomonomeren kondensiert, so erzielt man sogar noch höhere Lichtempfindlichkeiten.

**Patentansprüche**

1. Lichtempfindliches Polykondensationsprodukt aus wiederkehrenden Einheiten der allgemeinen Typen

$$[A - N_2X] \quad \text{und} \quad [Q]$$

dadurch gekennzeichnet, daß A der Rest einer Verbindung der allgemeinen Formel I

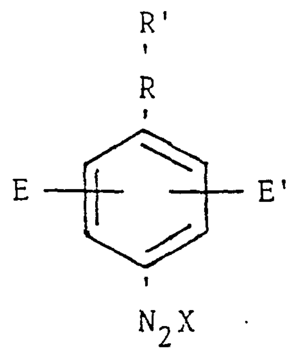

(I)

ist, worin
R′ eine substituierte oder unsubstituierte Phenylgruppe darstellt,
R -NH-, -S-, -O-, $-CH_2-$ oder eine Einfachbindung ist,
E und E′ gleich oder verschieden sein können und Alkyloder Alkoxygruppen mit 1 bis 4 C-Atomen oder Wasserstoffatome sind und
X das Anion des Diazoniumsalzes ist,
Q der Rest einer Verbindung der allgemeinen Formel II

$$R''-M(-Y-\overset{T}{M})_m-R'' \qquad (II)$$

ist, worin

R″ $-CH_2OH$, $-C(OH)(CH_3)_2$, $-CH_2O(CH_2)_nCH_3$,

$-CH_2O\overset{O}{\overset{\|}{C}}CH_3$, $-CH_2Cl$ oder $-CH_2Br$,

n 0 oder eine Zahl von 1 bis 3,
M der Rest eines aromatischen Kohlenwasserstoffs, Phenolethers, aromatischen Thioethers, aromatischen Amins, aromatischen Sulfons, aromatischen Ketons oder Diketons, wobei diese Grundkörper unsubstituiert oder durch Reste, die die Kondensationsreaktion nicht stören, substituiert sind,
m eine Zahl von 1 bis 6,
Y $-CH_2-$ oder $-CH_2OCH_2-$ und
T ein Wasserstoffatom ist, wenn Y $-CH_2-O-CH_2$ bedeutet, und ein Rest R″ ist, wenn Y $-CH_2-$bedeutet.

2. Polykondensationsprodukt nach Anspruch 1, dadurch gekennzeichnet, daß R die Gruppe -NH- ist.

3. Polykondensationsprodukt nach Anspruch 1, dadurch gekennzeichnet, daß M der Rest eines Diphenylethers, eines Diarylsulfids oder eines Diarylalkans ist.

4. Verfahren zur Herstellung eines Polykondensationsprodukts einer aromatischen Diazoniumverbindung, dadurch gekennzeichnet, daß man

a) in einem stark sauren Medium eine Verbindung der Formel R″-M-R″ so lange und bei solcher Temperatur kondensiert, daß ein Vorkondensationsprodukt der Formel II

$$R''-\overset{T}{M}(-Y-M)_m-R'' \qquad (II)$$

gebildet wird, worin

R'' $-CH_2OH$, $-C(OH)(CH_3)_2$, $-CH_2O(CH_2)_nCH_3$,

$-CH_2O\overset{O}{\overset{\|}{C}}CH_3$, $-CH_2Cl$ oder $-CH_2Br$,

n 0 oder eine Zahl von 1 bis 3,

M der Rest eines aromatischen Kohlenwasserstoffs, Phenolethers, aromatischen Thioethers, aromatischen Amins, aromatischen Sulfons, aromatischen Ketons oder Diketons, wobei diese Grundkörper unsubstituiert oder durch Reste, die die Kondensationsreaktion nicnt stören, substituiert sein können,

m eine Zahl von 1 bis 6,

Y $-CH_2-$ oder $-CH_2OCH_2-$ und

T ein Wasserstoffatom ist, wenn Y $-CH_2-O-CH_2-$bedeutet, und ein Rest R'' ist, wenn Y $-CH_2-$bedeutet, und

b) das erhaltene Vorkondensationsprodukt in stark saurem Medium mit einer Verbindung der Formel I

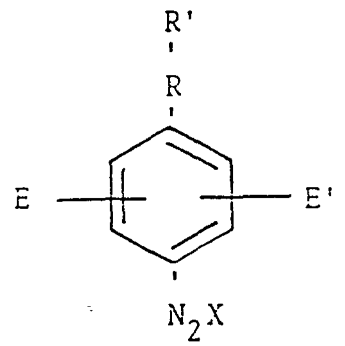

(I)

kondensiert, worin

R' eine substituierte oder unsubstituierte Phenylgruppe darstellt,

R -NH-, -S-, -O- $-CH_2-$ oder eine Einfachbindung ist,

E und E' gleich oder verschieden sein können und Alkyloder Alkoxygruppen mit 1 bis 4 C-Atomen oder Wasserstoffatome sind und

X das Anion des Diazoniumsalzes ist.

5. Verfahren nach Anspruch 4, dadurch gekennzeichnet, daß die Kondensationsstufen a) und b) in 80-100%iger Phosphorsäure als Kondensationsmedium durchgeführt werden.

6. Lichtempfindliches Aufzeichnungsmaterial aus einem Schichtträger und einer lichtempfindlichen Schicht, dadurch gekennzeichnet, daß die Schicht ein Polykondensationsprodukt gemäß Anspruch 1 enthält.

7. Lichtempfindliches Aufzeichnungsmaterial nach Anspruch 6, dadurch gekennzeichnet, daß die Schicht ferner ein polymeres Bindemittel enthält.

8. Lichtempfindliches Aufzeichnungsmaterial nach Anspruch 6, dadurch gekennzeichnet, daß der Schichtträger aus Aluminium besteht.

**Claims**

1. A light-sensitive polycondensation product comprising units of each of the general types

$$[A\text{-}N_2X] \quad \text{and} \quad [\ Q\ ]$$

characterized in that A is a radical of a compound of the general formula I

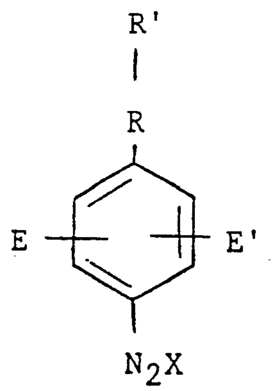

(I)

wherein
R is -NR-, -S-, -O-, $-CH_2-$ or a single bond,
R′ is a substituted or unsubstituted phenyl group,
E and E′ are identical or different and denote alkyl or alkoxy groups having from 1 to 4 carbon atoms, or hydrogen atoms,
X is the anion of the diazonium salt, and
Q is the radical of a compound of the general formula II

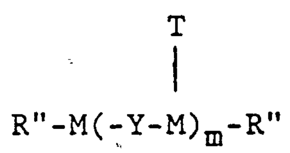

(II)

wherein
R″ is $-CH_2OH$, $-C(OH)(CH_3)_2$, $-CH_2O(CH_2)_nCH_3$, $-CH_2\text{-}OOCCH_3$, $-CH_2Cl$ and $-CH_2Br$,
n is 0 or an integer from 1 to 3,
M is a radical of an aromatic hydrocarbon, of a phenol ether, an aromatic thioether, an aromatic amine, an aromatic sulfone, an aromatic ketone or diketone, these radicals being unsubstituted or substituted by radicals which do not interfere with the condensation reaction,
m is a number from 1 to 6,
Y is $-CH_2-$ or $-CH_2\text{-}O\text{-}CH_2-$,
T is H when Y is $-CH_2\text{-}O\text{-}CH_2-$, and is a group R″ when Y is $-CH_2$.

2. A polycondensation product according to claim 1, in which R is an -NH-group.

3. A polycondensation product according to claim 1, in which M is the radical of a diphenyl ether, a diaryl sulfide 20 or a diaryl alkane.

4. A process for the preparation of a polycondensation product of an aromatic diazonium compound characterized by

a) condensing in a strong acid medium a compound of the formula R″-M-R″ at a temperature and for a time sufficient to form a precondensation product of the formula (II)

$$R''-\overset{T}{\overset{|}{M}}(-Y-M)_m-R'' \qquad (II)$$

wherein

R'' is $-CH_2OH$, $-C(OH)(CH_3)_2$, $-CH_2O(CH_2)_nCH_3$, $-CH_2-OOCCH_3$, $-CH_2Cl$ and $-CH_2Br$,

n is 0 or an integer from 1 to 3,

M is a radical of an aromatic hydrocarbon, of a phenol ether, an aromatic thioether, an aromatic amine, an aromatic sulfone, an aromatic ketone or diketone, these radicals being unsubstituted or substituted by radicals which do not interfere with the condensation reaction,

m is a number from 1 to 6,

Y is $-CH_2-$ or $-CH_2-O-CH_2-$,

T is H when Y is $-CH_2-O-CH_2-$, and is a group R'' when Y is $-CH_2-$, and

b) condensing in a strong acid medium the above precondensation product with a compound of the general formula I

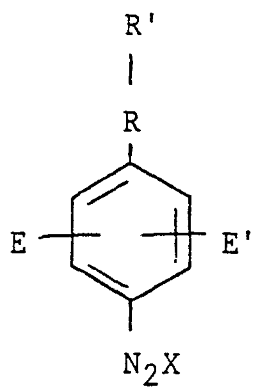

(I)

wherein

R is -NH-, -S-, -O-, $-CH_2-$ or a single bond,

R' is a substituted or unsubstituted phenyl group,

E and E' are identical or different and denote alkyl or alkoxy groups having from 1 to 4 carbon atoms, or hydrogen atoms, and

X is the anion of the diazonium salt.

5. A process according to claim 4, in which the condensation steps a) and b) are performed in 80 - 100 phosphoric acid as the condensation medium.

6. A photosensitive reproduction material comprising a support and a photosensitive layer, which layer includes a polycondensation product as defined in claim 1.

7. A photosensitive reproduction material according to claim 6, the layer of which further includes a polymeric binder.

8. A photosensitive reproduction material according to claim 6, wherein the support is an aluminium sheet.

**Revendications**

1 - Produit de polycondensation photosensible constitué de motifs répétés des types generaux:

$$[A-N_2X] \qquad et \qquad [Q]$$

caractérisé en ce que $[A-N_2X]$ est le radical d'un composé de formule générale

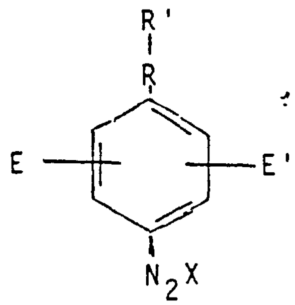

(I)

dans laquelle
R' représente un groupe phényle substitué ou non-substitué,
R est -NH-, -S-, -O-, $-CH_2-$ ou une simple liaison,
E et E' peuvent être identiques ou différents et sont des groupes alkoyle ou alkoxy ayant de 1 à 4 atomes de carbone ou des atomes d'hydrogène et
X est l'anion du sel de diazonium,
Q est le radical d'un composé de formule générale II,

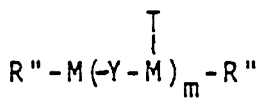

(II)

dans laquelle:
R'' est $-CH_2OH$, $-C(OH)(CH_3)_2$, $-CH_2O(CH_2)_nCH_3$,

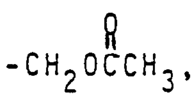 $-CH_2Cl$ ou $-CH_2Br$,

n est 0 ou un nombre de 1 à 3,
M est le radical d'un hydrocarbure aromatique, d'un phénoléther, d'un thioéther aromatique, d'une amine aromatique, d'une sulfone aromatique, d'une cétone ou d'une dicétone aromatique, ces groupes fondamentaux étant non-substitués ou substitués par des groupes qui ne gènent pas la. réaction de condensation,
m est un nombre 1 à 6,
Y est $-CH_2-$ ou $-CH_2OCH_2-$ et
T est un atome d'hydrogène, lorsque Y représente $-CH_2-O-CH_2-$, et un radical R'' lorsque Y représente $-CH_2-$.

2 - Produit de polycondensation selon la revendication 1, caractérisé en ce que R est le groupe NH.

3 - Produit de polycondensation selon la revendication 1, caractérisé en ce que M est le radical d'un diphényléther, d'un diarylsulfure ou d'un diarylalcane.

4 - Procédé pour la préparation d'un produit de polycondensation d'un composé diazoique aromatique, caractérisé en ce que

a) dans un milieu fortement acide, on condense un composé de formule R''-M-R'' aussi longtemps et à une température telle qu'il se forme un produit de précondensation de formule II

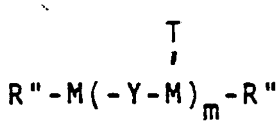

(II)

dans laquelle
R'' est $-CH_2OH$, $-C(OH)(CH_3)_2$, $-CH_2O(CH_2)_nCH_3$,

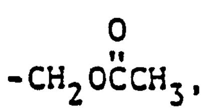 $-CH_2Cl$ ou $-CH_2Br$,

n est 0 ou un nombre de 1 à 3,

M est le radical d'un hydrocarbure aromatique, d'un phénoléther, d'un thioéther aromatique, d'une amide aromatique, d'une sulfone aromatique, d'une cétone ou d'une dicétone aromatique, ces groupes fondamentaux pouvant être nonsubstitués ou substitués par des groupes qui ne gènent pas la réaction de condensation,

m est un nombre de 1 à 6,

Y est-$CH_2$- ou-$CH_2OCH_2$- et

T est un atome d'hydrogéne lorsque Y est-$CH_2$-O-$CH_2$- et un radical R'' lorsque Y représente -$CH_2$-, et

b) on condense le produit de précondensation obtenu, dans un milieu fortement acide, avec un composé de formule I

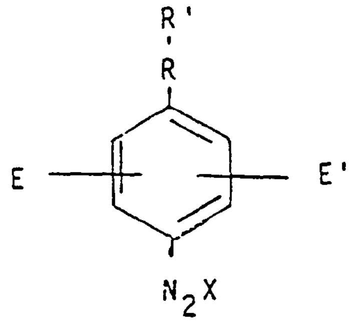

(I)

dans laquelle

R' représente un groupe phényle substitué ou non-substitué,

R est -NH-, -S-, -O-, -$CH_2$- ou une simple liaison,

E et E' peuvent être identiques ou différents et sont des groupes alkoyle ou alkoxy ayant de 1 à 4 atomes de carbone ou des atomes d'hydrogène et

X est l'anion du sel de diazonium.

5 - Procédé selon la revendication 4, caractérisé en ce que les opérations de condensation a) et b) sont effectuées dans de l'acide phosphorique à 80-100 % comme milieu de condensation.

6 - Matériau de reprographie photosensible composé d'un support de couche et d'une couche photosensible, caractérisé en ce que la couche contient un produit de polycondensation selon la revendication 1.

7 - Matériau de reprographie photosensible, selon la revendication 6, caractérisé en ce que la couche contient en outre un liant polymère.

8 - Matériau de reprographie photosensible selon la revendication 6, caractérisé en ce que le support de couche est en aluminium.